(19) Europäisches Patentamt
European Patent Office
Office européen des brevets

(11) **EP 2 940 850 A1**

(12) **EUROPEAN PATENT APPLICATION**

(43) Date of publication:
**04.11.2015 Bulletin 2015/45**

(51) Int Cl.:
**H02M 5/458** $^{(2006.01)}$     **G01R 31/42** $^{(2006.01)}$
**G01R 31/02** $^{(2006.01)}$

(21) Application number: **14460024.4**

(22) Date of filing: **29.04.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventors:
• **Lipnicki, Piotr**
  **20-861 Lublin (PL)**
• **Lewandowski, Daniel**
  **30-384 Krakow (PL)**

(74) Representative: **Chochorowska-Winiarska,**
**Krystyna**
**ABB Sp. z o. o.,**
**Ul. Zeganska 1**
**04-713 Warszawa (PL)**

(54) **A method for monitoring DC link capacitance in power converters**

(57) The subject of the invention is a method for monitoring DC link capacitance in power converters which is useful in condition monitoring of electronic equipment. The inventive method comprises the following steps: measuring current of the phase a, b, c and voltage of the DC link; determining inverter switch states of the inverter and rectifier switch states of the rectifier for each phase a, b, c; generating a trigger signal when the value of the inverter switch states of the inverter for each phase a, b, c have an equal values and determining a triggered time duration for the trigger signal; determining the rectifier switch states of the rectifier for each phase a, b, c at the triggered time duration and calculation current of the phase a, b, c and voltage of the DC link at the triggered time duration; reconstructing the DC link current at the triggered time duration; calculating an indicator ERS (Equivalent Series Resistance) for the DC link voltage at the triggered time duration; calculating a total DC link capacitance C and comparing it with the initial DC link capacitance. When the initial DC link capacitance is bigger than a threshold value given by user then and triggering an alarm.

Fig. 1

EP 2 940 850 A1

**Description**

The subject of the invention is a method, a system and a computer program for monitoring DC link capacitance in power converters which is useful in condition monitoring of electronic equipment.

BACKGROUND OF THE INVENTION

Many of converters applications are being considered as critical for plant production process. Offering enhanced functionality in modern power converters is a way to gain a competitive advantage in worldwide market. One of the values to the customers comes from low cost condition monitoring of critical equipment and from optimized maintenance costs. DC link is one of the elements of power converters circuits. Although the designers pay a lot of attention when designing DC link, breakdowns and failures of the DC link can still happen. Unfortunately this means that the whole converter must be shutdown in emergency mode to be repaired. Nowadays, monitoring of the DC link is becoming one of the desired features from customer side, as well as from the converter manufacturer.

The ever-increasing demands for greater efficiency and reliability of power converters, force the introduction of novel methods for improving their performance. One of the ways is to provide a detailed condition monitoring features for the elements of the converter, ensuring tracking of entire device status. Assuring proper monitoring of the DC link capacitance level is one of the solutions for converter status determination. The capacitor deterioration usually manifests by an increase in ESR and decrease in an effective capacitance. Earlier detection of the ESR increase allows for preventive mitigation actions - i.e. scheduling shutdown and repairs. Moreover it also helps with evaluation of the expected operational time until failure may happen. Preventing the growth of ESR values over a specified level provides maintaining the quality of converted power and protects the converter from DC-link failure.

There is known from patent US 2010/0295554 A1 a method and system for monitoring the condition of the capacitor arrangement of the DC-voltage intermediate circuit of a power electronics appliance, such as of a frequency converter, at the place of usage, in which method the discharge voltage over the capacitor arrangement as a function of time is measured, and in which method the intermediate circuit is pre-charged With a pre-determined DC voltage, the pre-charging is removed from the intermediate circuit, the voltage of the intermediate circuit is measured by sampling at regular intervals, the voltage drop as a function of time is determined on the basis of the measured voltage of the intermediate circuit, the capacitance or the relative change in it is determined on the basis of the voltage drop, the value of the determined capacitance or of the relative change in it is compared to a pre-determined limit value on the basis of the voltage drop, and the necessary condition monitoring procedure is performed when the value determined with the measurement reaches the pre-determined limit value or is close to it. The disadvantage of the method is the need for performing initial measurement of the discharge curve and performing the measurements each time before starting the converter, thus it cannot be used online continuously.

There is known from patent US6381158B1 a system and method for monitoring DC link capacitance in three level inverters where a signal is injected into a neutral point regulator of an inverter drive and the response to that injected signal is monitored as an indication of the capacitance of the inverter drive. The disadvantage of the method is the need of additional passive elements used for additional device which is responsible for signal injecting.

**SUMMARY OF THE INVENTION**

The presented invention provides a diagnostic method for monitoring DC link in power converters according to claim 1 and a system for implementing the method according to claim 5. The present invention provides also a computer program for monitoring DC link capacitance in a power converters according to claim 7, which computer program is loadable in and executable on a data processing unit of a computer device and which computer program performs when being executed by the data processing unit of a computer device, the method according to claim 1-4. The computer device can be a converter control unit and DC link monitoring unit, where at least one of these units is equipped with the data processing unit.

The presented invention is advantageous relative to the previously described existing methods as it allows for monitoring of the DC link using less measurement devices inside the power converter, namely only DC link voltage measuring device is used. Moreover in the method according to the invention the calculation process is simplified and thus does not required a significant calculation power. Also by using synchronization with inverter switching signal further simplification in software by reducing algorithm complexity and in hardware by reducing number of elements is achieved, so the inventive method allows for saving time during monitoring DC link capacitance.

BRIEF DESCRIPTION OF THE DRAWINGS

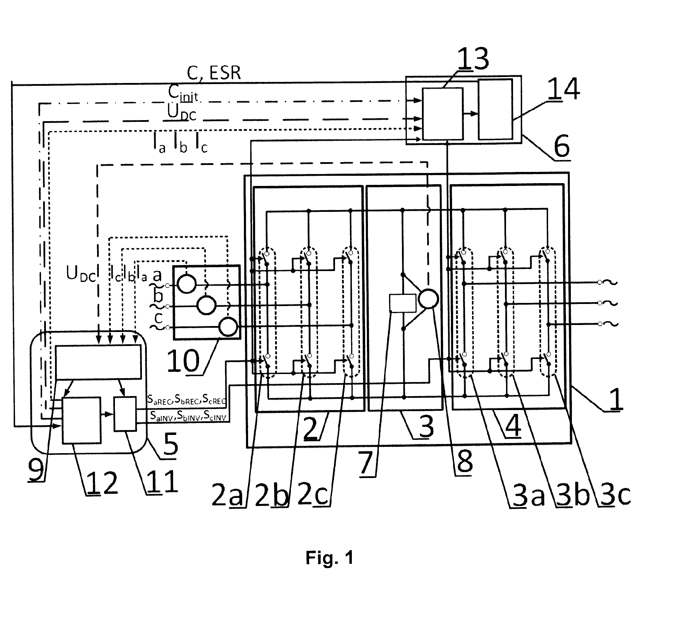

Fig.1 - is a picture of power converter equivalent system,

Fig.2 - is a diagram of operations performed for method for monitoring DC link in accordance with the invention,

Fig.3 - is an electrical scheme of basic DC link circuit,

Fig. 4 - is a plot of measured parameters during time period for indicating consecutive triggering signals $S_{TRIG}$,

Fig. 5 - is a plot of measured current during time period for presenting the DC-link current reconstruction principle.

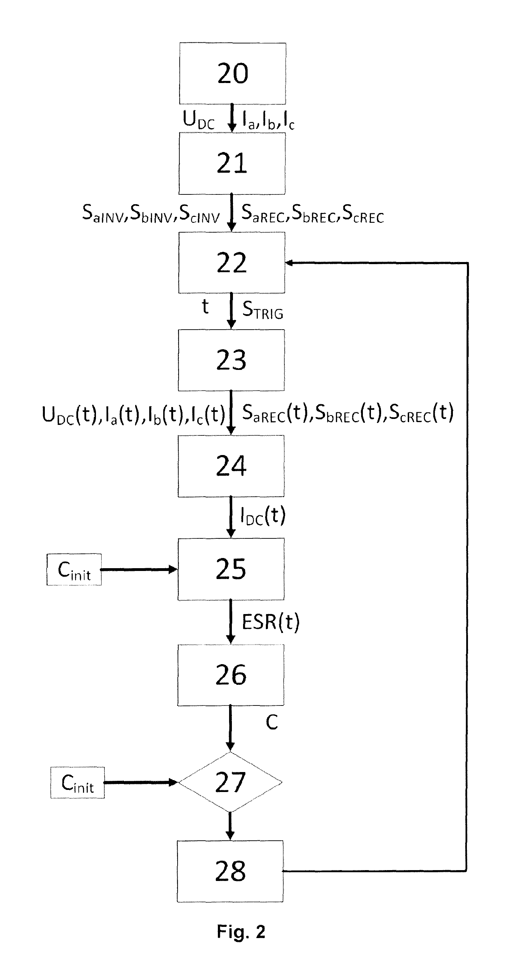

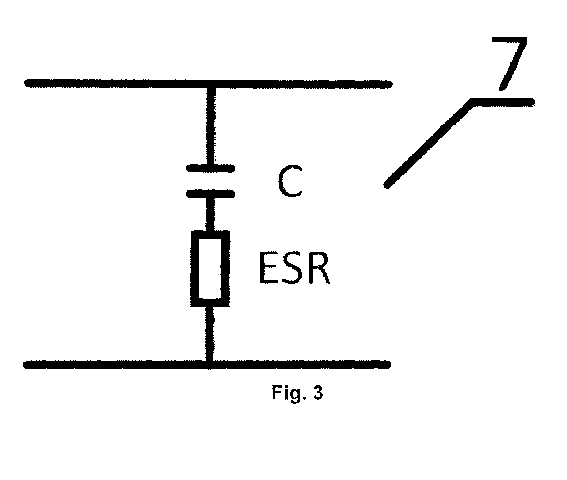

A power converter system comprises a power converter circuit 1 having a rectifying unit 2, a DC link unit 3, an inverter unit 4, and the power converter circuit 1 is connected with a converter control unit 5 and a DC link monitoring unit 6. The converter control unit 5 and the DC link monitoring unit 6 may be combined in single unit what is not presented in the drawing. The power converter circuit 1, the control unit 5 and DC link monitoring unit 6 are powered by three phase power supply lines a, b, c. The rectifying unit 2 has at least two solid state switches 2a, 2b, 2c, forming an inverter switching leg for each phase a, b, c, for converting the AC input voltage into DC output voltage. The solid state switches of the rectifying unit 2 is one of the possible known kinds - e.g. diodes, transistors, thyristors, etc. The DC link unit 3 includes at least one DC link circuit 7 and a DC link voltage measuring device 8. DC link circuit 7 comprises capacitor and an equivalent of series resistance ESR presented in figure 3. The inverter unit 4 has at least two solid state switches 3a, 3b, 3c, forming an rectify switching leg for each phase a, b, c, for converting the DC input voltage into AC output voltage. The solid state switches of the inverting unit 4 can be one of the possible known kinds - e.g. transistors, thyristors etc. The converter control unit 5 is a computer device, having a data acquisition module 9 for receiving and processing input signals such as: current $I_a$, $I_b$, $I_c$, measured by the sensors 10 mounted on power supply lines a, b, c, and a voltage $U_{DC}$ of DC link unit 3, connected to the circuit 7. The converter control unit 5 is also equipped with an output module 11 for generating switching signals for solid switches 2a, 2b, 2c of the rectifying unit 2 and for solid switches 3a, 3b, 3c of the inverting unit 3. The converter control unit 5 is also equipped with an alarm generating module 12, for comparing the initial capacitance $C_{int}$ and total capacitance C, and for generating alarm if certain condition is met. The DC link monitoring unit 6 is a computer device, having processing unit 13 for receiving and processing input signals such as: current $I_a$, $I_b$, $I_c$ and a voltage $U_{DC}$ of DC link unit 3, and signals from switches 2a, 2b, 2c, 3a, 3b, 3c. The DC link monitoring unit 6 is equipped with the calculation module 14 for calculating an indicator of ESR (Equivalent Series Resistance) and for calculation a total capacitance C of the DC link unit 3.
The inventive method is implemented according to the following steps 20-28 presented in fig.2.

Step 20

Measuring a DC link voltage $U_{DC}$ by the DC link voltage measuring device 8 and measuring current $I_a$, $I_b$, $I_c$ of three phase power supply lines a, b, c , by the sensors 10.

Step 21

Calculation inverter switching signals $S_{aINV}$, $S_{bINV}$, $S_{cINV}$ of the inverter unit 3 and rectifier switching signals $S_{aREC}$, $S_{bREC}$, $S_{cREC}$ of the rectifier unit 2 in the converter control unit 5, using known control methods for such calculation e.g. field oriented control method, scalar control method, direct torque control method, and sending calculated data to the rectifier unit 2, the inverter unit 3 and DC link monitoring unit 6. The calculation is realized in the converter control unit 5. The switching signals can take the following values, according to the formulae's:

$$S_{aREC} = \begin{cases} 1, \\ 0 \end{cases} ; \; S_{bREC} = \begin{cases} 1, \\ 0 \end{cases} ; \; S_{cREC} = \begin{cases} 1, \\ 0 \end{cases}$$
$$S_{aINV} = \begin{cases} 1, \\ 0 \end{cases} ; \; S_{bINV} = \begin{cases} 1, \\ 0 \end{cases} ; \; S_{cINV} = \begin{cases} 1, \\ 0 \end{cases} \tag{1}$$

Step 22

Generating a trigger signal $S_{TRIG}$ by comparison each individual switching signal with all remaining switching signals and when $Sa_{INV}==S_{bINV}==S_{cINV}$ then the trigger signal $S_{TRIG}$ has a value equal to 1.

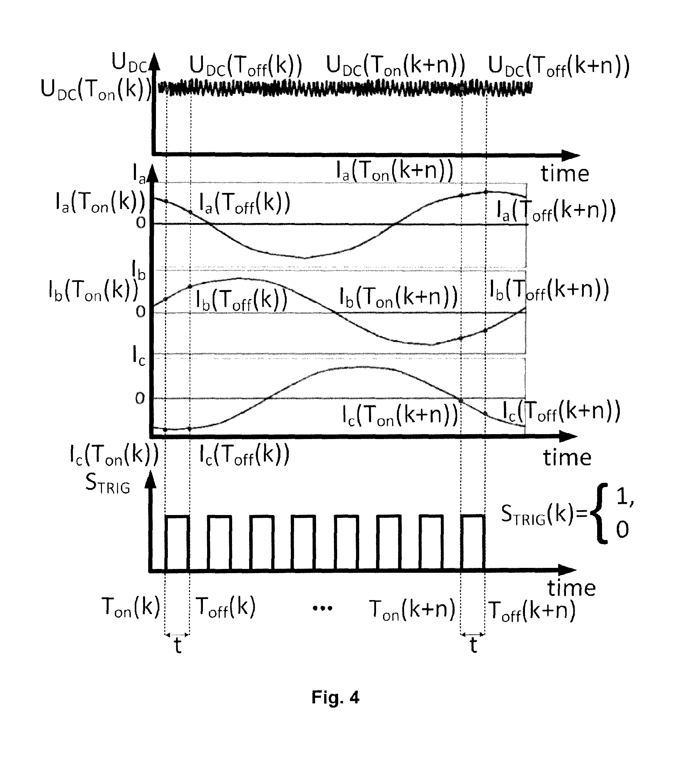

Determination of triggered time duration t for the trigger signal $S_{TRIG}$ and indicate measured current $I_a$, $I_b$, $I_c$ in the time t as $I_a(t)$, $I_b(t)$, $I_c(t)$, where triggered time duration t is defined as the time between start $T_{on}$ and stop $T_{off}$ of the trigger signal $S_{TRIG}$, where k - n are consecutive number of triggered time duration t, what is presented in the fig. 4 and described according to the formulae:

$$T_{on}(k) < t < T_{off}(k) \cdots T_{on}(k + n) < t < T_{off}(k + n) \tag{2}$$

Step 23

Determination switching signals $S_{aREC}$, $S_{bREC}$, $S_{cREC}$ of the rectifying unit 2 from the converter control unit 5 at the triggered time t as $S_{aREC}(t)$, $S_{bREC}(t)$, $S_{cREC}(t)$ and determination of the DC link voltage $U_{dc}$ and current $I_a$, $I_b$, $I_c$ of three phase power supply lines a, b, c at the triggered time t as $U_{dc}(t)$, $I_a(t)$, $I_b(t)$, $I_c(t)$.

Step 24

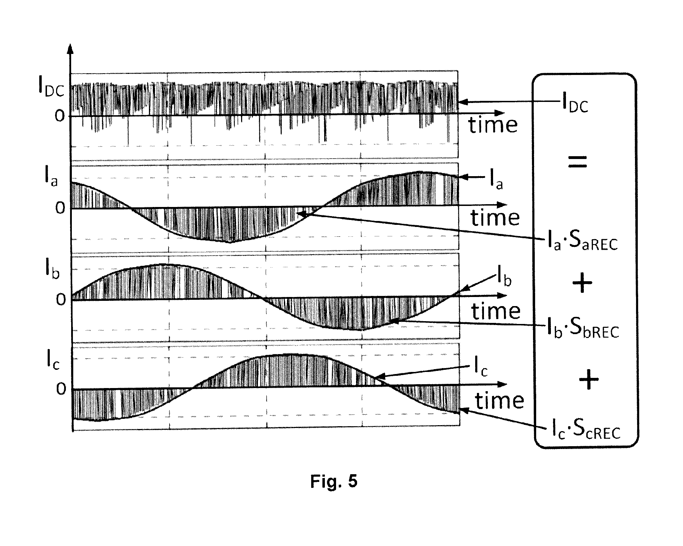

Reconstructing the DC link current by multiplying phase current $I_a(t)$, $I_b(t)$, $I_c(t)$ at the triggered time t by corresponding rectify switching signal $S_{aREC}(t)$, $S_{bREC}(t)$, $S_{cREC}(t)$ at the triggered time t and making a sum of all results what is presented in fig. 5 and described according to the formulae:

$$I_{DC}(t) = S_{aREC}(t) \cdot I_a(t) + S_{bREC}(t) \cdot I_b(t) + S_{cREC}(t) \cdot I_c(t) \tag{3}$$

where:

$I_a(t)$ - is a measured current for phase a, at the triggered time t,
$I_b(t)$, - is a measured current for phase b, at the triggered time t,
$I_c(t)$, - is a measured current for phase c, at the triggered time t,
$Sa_{REC}(t)$, - is a value of switching signal of the rectifying unit for phase a, at the triggered time t,
$S_{bREC}(t)$, - is a value of switching signal of the rectifying unit for phase b, at the triggered time t,
$S_{cREC}(t)$, - is a value of switching signal of the rectifying unit for phase c, at the triggered time t.

Step 25

Calculating an indicator of an Equivalent Series Resistance (ESR) in monitoring unit 6 for the DC link voltage $U_{DC}$ measured voltage, according to the formula:

$$ESR(t) = \int_{T_{on}}^{T_{off}} \frac{\frac{dU_{DC}(t)}{dt} - \frac{I_{DC}(t)}{C_{init}}}{\frac{dI_{DC}(t)}{dt}} dt \tag{4}$$

where:

$U_{DC}(t)$- is measured DC link voltage at the triggered time t,
$C_{int}$ - is initial DC link capacitance stored in the converter control unit 5,
$I_{DC}(t)$ - is calculated DC link current, at the triggered time t,
$T_{on}$ - is the start time of the triggered signal $S_{TRIG}$,
$T_{off}$ - is the stop time of the triggered signal $S_{TRIG}$.

Step 26

Calculating the total DC link capacitance C (in percent's) using the calculated DC link current, calculated ESR indicator and measured DC link voltage, according to the formulae:

$$C\ [\%] = \frac{(I_{DC}(t) \cdot ESR(t) - U_{DC}(t))^2}{U_{DC}^2(t)} \cdot 100\% \tag{5}$$

where:

$I_{DC}(t)$ - is calculated reconstructed DC link current,
$U_{DC}(t)$ - is measured DC link voltage,
$ESR(t)$ - is calculated equivalent series resistance.

Step 27

Comparing the initial capacitance $C_{init}$ with the calculated total capacitance C in alarm generating module 12, according to the formulae:

$$C\ [\%] < k_p \cdot C_{init}[\%] \tag{6}$$

Where the value of $k_p$ is a threshold value given by user depended on a nominal power of the converter, for example for the converter of 1 MW power the value of $k_p$ is preferably 0.7.

Step 28

Generating an alarm if the threshold value is exceeded and sending a command from alarm generating module 12 to the output module 11 where rectify switching signals $S_{aREC}$, $S_{bREC}$, $S_{cREC}$ of rectifying unit 2 and inverter switching signals $S_{aINV}$, $S_{bINV}$, $S_{cINV}$ of inverter unit 4, are set to 0, which signals automatically switched off the converter circuit 1. In all other situations steps 22-27 are repeated.

**Claims**

1. A method for monitoring DC link capacitance in power converters comprises the following steps:

    - measuring current of the phase a, b, c,
    - measuring voltage of the DC link unit 3 and setting initial capacitance $C_{int}$ of the DC link, where the initial capacitance of the DC link is given by the user,
    - determining inverter switch states of the inverter and rectifier switch states of the rectifier for each phase a, b, c, where the switching states have a value equal to 0 or 1,
    - generating a trigger signal $S_{TRIG}$ when the value of the inverter switch states of the inverter for each phase a, b, c have an equal values and determining a triggered time duration t for the generated trigger signal,
    - determining the rectifier switch states of the rectifier unit 2 for each phase a, b, c at the triggered time duration t and calculation current of the phase a, b, c and voltage of the DC link at the triggered time duration t,
    - reconstructing the DC link current at the triggered time duration t,
    - calculating an indicator ERS (Equivalent Series Resistance) for the DC link voltage at the triggered time duration t,
    - calculating a total DC link capacitance C,
    - comparing the value of total DC link capacitance C with the initial DC link capacitance $C_{int}$ and triggering an alarm when the initial DC link capacitance $C_{int}$ is bigger than a threshold value given by user.

2. A method according to claim 1 **characterized in that** the indicator ERS is calculated according the following formulae:

$$ESR(t) = \int_{T_{on}}^{T_{off}} \frac{\frac{dU_{DC}(t)}{dt} - \frac{I_{DC}(t)}{C_{init}}}{\frac{dI_{DC}(t)}{dt}} \, dt$$

where:

$U_{DC}(t)$- is a measured DC link voltage at the triggered time duration t,
Cinit - is initial DC link capacitance given by the user and stored in the converter control unit,
$I_{DC}(t)$- is a reconstructed current od DC link at the triggered time duration t,
$T_{on}$ - is the start time of the triggered signal $S_{TRIG}$,
$To_{ff}$ - is the stop time of the triggered signal $S_{TRIG}$.

**3.** A method according to claim 1 **characterized in that** DC link reconstructed current $I_{DC}(t)$ is calculated according to the formulae:

$$I_{DC}(t) = S_{aREC}(t) \cdot I_a(t) + S_{bREC}(t) \cdot I_b(t) + S_{cREC}(t) \cdot I_c(t)$$

where:

la(t) - is a measured current for phase a at the triggered time duration t,
$I_b(t)$ - is a measured current for phase b at the triggered time duration t
$I_c(t)$ - is a measured current for phase c at the triggered time duration t,
$S_{aREC}(t)$- is a value of switching signal of the rectifying unit for phase a at the triggered time duration t,
$S_{bREC}(t)$- is a value of switching signal of the rectifying unit for phase b at the triggered time duration t,
$S_{cREC}(t)$ - is a value of switching signal of the rectifying unit for phase c at the triggered time duration t.

**4.** A method according to any of the previous claims, **characterized in that** the total DC link capacitance is calculated according to the formulae:

$$C\,[\%] = \frac{(I_{DC}(t) \cdot ESR(t) - U_{DC}(t))^2}{U_{DC}^2(t)} \cdot 100\%$$

where:

$I_{DC}(t)$ - is calculated DC link current at the triggered time duration t,
$U_{DC}(t)$ - is measured DC link voltage at the triggered time duration t,
$ESR(t)$ - is calculated equivalent series resistance indicator at the triggered time duration t.

**5.** A system for monitoring DC link capacitance in power converter comprising a power converter circuit (1) with a rectifying unit (2), a DC link unit (3), an inverter unit (4) which are connected with a converter control unit (5) and with a DC monitoring unit (6) and with means for measuring electrical parameters of the system, **characterized in that** it further comprising:

- means for setting initial capacitance $C_{int}$ of the DC link, where the initial capacitance of the DC link is given by the user in a computer device,
- means for determining inverter switch states of the inverter unit (4) and means for determining rectifier switch states of the rectifier unit (2) for each phase a, b, c, implemented in the computer device,
- means for comparing the value of inverter switch states and for generating a trigger signal $S_{TRIG}$ when the value of the inverter switch states of the inverter unit (4) for each phase a, b, c have an equal values, implemented in the converter control unit (5),
- means for determining a triggered time duration t, implemented in the converter control unit (5),
- means for determining the rectifier switch states of the rectifier unit (2) for each phase a, b, c at the triggered time duration t and calculation current of the phase a, b, c and voltage of the DC link unit (3) at the triggered time duration t,
- means for reconstructing the DC link current at the triggered time duration t,
- means for calculating an indicator ERS (Equivalent Series Resistance) for the DC link unit (3) voltage at the triggered time duration t and means for calculating a total DC link unit (3) capacitance C,
- means for comparing the value of total DC link unit (3) capacitance C with the initial DC link capacitance $C_{int}$,
- means for triggering an alarm when the initial DC link capacitance $C_{int}$ is bigger than a threshold value given by user.

6. A system according to claim 5, characterized that the converter circuit 1 comprises solid switches (2a,2b,2c) and (3a,3b,3c) connected to the switching legs of the rectifying unit (2) and inverter unit 4 respectively.

7. A system according to claim 6, **characterized in that** the solid switches (2a,2b,2c) and (3a,3b,3c) have a form of diodes or transistors or thyristors.

8. A computer program for monitoring DC link capacitance in power converter system, which computer program is loadable in and executable on a data processing unit (13) of a computer device having a form of a DC monitoring device (6) and which computer program performs when being executed by the data processing unit (13) of the computer device, the method according to claims 1-4.

**Fig. 1**

$$\boxed{20}$$

$U_{DC}$ $\downarrow$ $I_a, I_b, I_c$

$$\boxed{21}$$

$S_{aINV}, S_{bINV}, S_{cINV}$ $\quad$ $S_{aREC}, S_{bREC}, S_{cREC}$

$$\boxed{22}$$

$t$ $\downarrow$ $S_{TRIG}$

$$\boxed{23}$$

$U_{DC}(t), I_a(t), I_b(t), I_c(t)$ $\quad$ $S_{aREC}(t), S_{bREC}(t), S_{cREC}(t)$

$$\boxed{24}$$

$\downarrow$ $I_{DC}(t)$

$\boxed{C_{init}} \longrightarrow$ $\boxed{25}$

$\downarrow$ $ESR(t)$

$$\boxed{26}$$

$\downarrow$ $C$

$\boxed{C_{init}} \longrightarrow$ $\langle 27 \rangle$

$$\boxed{28}$$

**Fig. 2**

9

Fig. 3

Fig. 4

**Fig. 5**

Europäisches
Patentamt

European
Patent Office

Office européen
des brevets

# EUROPEAN SEARCH REPORT

Application Number

EP 14 46 0024

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/072839 A1 (KIM MYUNG CHUL [KR] ET AL) 19 March 2009 (2009-03-19) | 1,5-8 | INV. H02M5/458 G01R31/42 G01R31/02 |
| A | * paragraph [0046] - paragraph [0047]; figure 1 * * paragraph [0061] - paragraph [0064] * | 2-4 | |
| A | EP 0 652 445 A2 (HONDA MOTOR CO LTD [JP]) 10 May 1995 (1995-05-10) * claim 2; figures 4,7 * | 1,5,8 | |
| A | US 2013/155729 A1 (LEE KEVIN [US] LI HUAQIANG [US]) 20 June 2013 (2013-06-20) * paragraph [0068] - paragraph [0070]; figure 1 * | 1,5,8 | |
| A,D | US 2010/295554 A1 (ALHO TIMO [FI]) 25 November 2010 (2010-11-25) * the whole document * | 1,5,8 | |

TECHNICAL FIELDS
SEARCHED (IPC)

H02M
G01R

The present search report has been drawn up for all claims

| Place of search | Date of completion of the search | Examiner |
|---|---|---|
| The Hague | 7 November 2014 | Imbernon, Lisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 14 46 0024

This annex lists the patent family members relating to the patent documents cited in the above-mentioned European search report.
The members are as contained in the European Patent Office EDP file on
The European Patent Office is in no way liable for these particulars which are merely given for the purpose of information.

07-11-2014

| Patent document cited in search report | | Publication date | Patent family member(s) | | Publication date |
|---|---|---|---|---|---|
| US 2009072839 | A1 | 19-03-2009 | KR | 20090029333 A | 23-03-2009 |
| | | | US | 2009072839 A1 | 19-03-2009 |
| EP 0652445 | A2 | 10-05-1995 | DE | 69428326 D1 | 25-10-2001 |
| | | | DE | 69428326 T2 | 18-04-2002 |
| | | | DE | 69433701 D1 | 13-05-2004 |
| | | | DE | 69433701 T2 | 17-03-2005 |
| | | | EP | 0652445 A2 | 10-05-1995 |
| | | | EP | 1046923 A2 | 25-10-2000 |
| | | | EP | 1326085 A2 | 09-07-2003 |
| | | | US | 5497095 A | 05-03-1996 |
| | | | US | 5694051 A | 02-12-1997 |
| | | | US | 5798648 A | 25-08-1998 |
| US 2013155729 | A1 | 20-06-2013 | AU | 2012352637 A1 | 15-05-2014 |
| | | | CA | 2853684 A1 | 20-06-2013 |
| | | | CN | 104040441 A | 10-09-2014 |
| | | | EP | 2791743 A2 | 22-10-2014 |
| | | | US | 2013155729 A1 | 20-06-2013 |
| | | | WO | 2013090112 A2 | 20-06-2013 |
| US 2010295554 | A1 | 25-11-2010 | CN | 101918852 A | 15-12-2010 |
| | | | EP | 2235548 A2 | 06-10-2010 |
| | | | FI | 20085047 A | 22-07-2009 |
| | | | US | 2010295554 A1 | 25-11-2010 |
| | | | WO | 2009092848 A2 | 30-07-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100295554 A1
- US 6381158 B1